# EUROPEAN PATENT APPLICATION

(11) **EP 4 788 096 A1**
(43) Date of publication of application: **05.08.2026**
(21) Application number: 25799167.9
(22) Date of filing: 21.10.2025
(51) Int. Cl.: H10F 77/30, H10F 71/00

(54) **SOLAR CELL AND PREPARATION METHOD THEREFOR, AND PHOTOVOLTAIC MODULE**

(30) Priority: 25.10.2024 CN 202411506108
(71) Applicant: Jinko Solar Co., Ltd., Jiangxi 334100 (CN); Zhejiang Jinko Solar Co., Ltd., Haining, Zhejiang 314416 (CN)
(72) Inventor: JIN, Jingsheng, Jiangxi 334100 (CN); CUI, Wei, Jiangxi 334100 (CN); LIU, Changming, Jiangxi 334100 (CN); ZHANG, Xinyu, Jiangxi 334100 (CN)
(74) Representative: Balder IP Law, S.L.
(86) International application number: PCT/CN2025/129039
(87) International publication number: WO 2026/086797

(57) **Abstract**

The present disclosure relates to the field of solar cells, and provides a solar cell and a method for fabricating the same, which can at least solve the problem of poor performance of segmented cells. The solar cell includes: a first surface, a second surface, and a third surface connecting the first surface and the second surface, where the first surface is a front surface of the solar cell, and the second surface is a rear surface of the solar cell; a passivation region, where the passivation region is located on the third surface; a silicon oxide layer, where the silicon oxide layer is located on a surface of the passivation region; and a metal oxide layer, where the metal oxide layer is located on the silicon oxide layer.

## Description

### CROSS REFERENCE TO RELATED APPLICATIONS

This application claims priority to Chinese Patent Application No. 202411506108.8, filed on October 25, 2024, and entitled "SOLAR CELL AND METHOD FOR FABRICATING THE SAME," which is incorporated by reference herein in its entirety.

### TECHNICAL FIELD

The present disclosure relates to the field of solar cells, and in particular, to a solar cell and a method for fabricating the same, and a photovoltaic module.

### BACKGROUND

At present, with the gradual depletion of fossil energy, solar cells are increasingly used as a new energy alternative. A solar cell is a device that converts solar light energy into electrical energy. The solar cell uses the photovoltaic principle to generate carriers, and then uses electrodes to extract the carriers, thereby facilitating the effective use of electrical energy.

Current solar cells mainly include Interdigitated Back Contact (IBC) cells, Tunnel Oxide Passivated Contact (TOPCON) cells, Passivated Emitter and Rear Cells (PERC cells), heterojunction cells, and the like. Through different film layer settings and functional limitations, optical losses are reduced and the recombination of photogenerated carriers on the surface and in the bulk of the silicon substrate is reduced, thereby improving the photoelectric conversion efficiency of the solar cell.

In the process of assembling cell pieces into a cell string, a whole cell is usually cut into pieces, and the segmented cell pieces are assembled into a cell string, thereby reducing packaging losses, optimizing links in the module production process, improving module reliability, and also reducing manufacturing costs. However, this technology also brings some new challenges and problems, such as the probability of cell cracking and efficiency loss at the cutting surface, which need to be further optimized and improved.

### SUMMARY

Embodiments of the present disclosure provide a solar cell and a method for fabricating the same, and a photovoltaic module, which are at least conducive to solving the problem of poor performance of segmented cells.

According to some embodiments of the present disclosure, an aspect of the embodiments of the present disclosure provides a solar cell, including: a first surface, a second surface, and a third surface connecting the first surface and the second surface, where the first surface is a front surface of the solar cell, and the second surface is a rear surface of the solar cell; a passivation region, where the passivation region is located on the third surface; a silicon oxide layer, where the silicon oxide layer is located on a surface of the passivation region; and a metal oxide layer, where the metal oxide layer is located on the silicon oxide layer.

In some embodiments, the passivation region includes an amorphous silicon layer or a microcrystalline silicon layer.

The passivation region has a thickness of 1 nm to 10 nm.

In some embodiments, the metal oxide layer is prepared by a low-temperature process.

In some embodiments, the silicon oxide layer has a thickness of 1 nm to 10 nm.

In some embodiments, an angle between the first surface and the third surface is an acute angle.

In some embodiments, the solar cell further includes: an intermediate passivation region, where the intermediate passivation region is located between the silicon oxide layer and the metal oxide layer, and the intermediate passivation region includes at least one of silicon element from the silicon oxide layer or metal element from the metal oxide layer.

In some embodiments, the intermediate passivation region includes the metal element, and along a direction from the silicon oxide layer toward the metal oxide layer, the content of the metal element increases.

In some embodiments, the metal oxide layer has a thickness of 20 nm to 100 nm.

In some embodiments, the intermediate passivation region has a thickness of 4 nm to 15 nm.

According to some embodiments of the present disclosure, another aspect of the embodiments of the present disclosure provides a method for fabricating a solar cell, including: providing a whole solar cell, where the whole solar cell includes a front surface and a rear surface that are oppositely disposed; performing a cutting process on the whole solar cell to form at least two solar cells, where each solar cell includes a first surface, a second surface, and a third surface connecting the first surface and the second surface, the first surface is a part of the front surface of the whole solar cell, the second surface is a part of the rear surface of the whole solar cell, and the third surface is a section of the solar cell after the cutting process; forming a passivation region, where the passivation region is located on the third surface; forming a silicon oxide layer, where the silicon oxide layer is located on a surface of the passivation region; and forming a metal oxide layer, where the metal oxide layer is located on the silicon oxide layer.

In some embodiments, reaction temperatures for forming the passivation region, the silicon oxide layer, and the metal oxide layer are all less than or equal to 300°C.

In some embodiments, the solar cell includes a substrate, and forming the passivation region includes: performing laser treatment on the substrate to convert a partial thickness of the substrate into the passivation region.

In some embodiments, process parameters of the laser treatment include: a laser wavelength of 300 nm to 550 nm, a pulse width of 5 ps to 100 ns, a laser power of 1 W to 25 W, a pulse frequency of 50 kHz to 1250 kHz, a spot area of 5000 µm² to 50000 µm², and a scanning speed of 300 mm/s to 80000 mm/s.

According to some embodiments of the present disclosure, yet another aspect of the embodiments of the present disclosure provides a photovoltaic module, including: a cell string, formed by connecting a plurality of solar cells according to any one of the above embodiments or solar cells fabricated by the method according to any one of the above embodiments; an encapsulation film, configured to cover a surface of the cell string; and a cover plate, configured to cover a surface of the encapsulation film away from the cell string.

### BRIEF DESCRIPTION OF THE DRAWINGS

One or more embodiments are illustrated by way of example in the accompanying drawings, which do not constitute limitations on the embodiments. The figures in the accompanying drawings are not necessarily to scale unless specifically stated. In order to more clearly illustrate the embodiments of the present disclosure or the technical solutions in the related art, the drawings used in the embodiments will be briefly introduced below. Obviously, the drawings in the following description are only some embodiments of the present disclosure, and for those of ordinary skill in the art, other drawings can be obtained based on these drawings without creative effort.
FIG. 1 is a first top view of a solar cell according to an embodiment of the present disclosure;
FIG. 2 is a first cross-sectional view of a segmented cell in a solar cell according to an embodiment of the present disclosure;
FIG. 3 is a second top view of a solar cell according to an embodiment of the present disclosure;
FIG. 4 is a third top view of a solar cell according to an embodiment of the present disclosure;
FIG. 5 is a second cross-sectional view of a segmented cell in a solar cell according to an embodiment of the present disclosure;
FIG. 6 is a third cross-sectional view of a segmented cell in a solar cell according to an embodiment of the present disclosure;
FIG. 7 is a fourth cross-sectional view of a segmented cell in a solar cell according to an embodiment of the present disclosure;
FIG. 8 is a fifth cross-sectional view of a segmented cell in a solar cell according to an embodiment of the present disclosure;
FIG. 9 is a sixth cross-sectional view of a segmented cell in a solar cell according to an embodiment of the present disclosure;
FIG. 10 is a cross-sectional view of a segmented cell during a method for fabricating a solar cell according to an embodiment of the present disclosure;
FIG. 11 is a cross-sectional view of a photovoltaic module according to an embodiment of the present disclosure.

### DETAILED DESCRIPTION OF THE EMBODIMENTS

As can be seen from the background part, conventional segmented cells have poor performance.

The solar cell provided by the embodiments of the present disclosure, by disposing a crystalline silicon layer, a silicon oxide layer, and a metal oxide layer on the third surface of a segmented cell, and performing passivation treatment on the third surface through a multi-layer passivation structure, reduces the recombination rate at the cut section of the segmented cell without damaging the performance of the original segmented cell, thereby improving the performance of the segmented cell.

In the description of the embodiments of the present disclosure, the technical terms "first," "second," and the like are used only to distinguish different objects and should not be understood as indicating or implying relative importance or implicitly specifying the quantity, specific order, or primary-secondary relationship of the indicated technical features. In the description of the embodiments of the present disclosure, "a plurality of" means two or more, unless otherwise specifically defined.

The "embodiment" mentioned in the present disclosure means that a specific feature, structure, or characteristic described in connection with the embodiment may be included in at least one embodiment of the present disclosure. The appearance of this phrase in various places in the specification does not necessarily refer to the same embodiment, nor is it an independent or alternative embodiment mutually exclusive with other embodiments. Those skilled in the art explicitly and implicitly understand that the embodiments described herein may be combined with other embodiments.

In the description of the embodiments of the present disclosure, the term "and/or" is only a descriptive relationship of associated objects, indicating that three relationships may exist, for example, A and/or B may indicate: existence of A alone, simultaneous existence of A and B, and existence of B alone. In addition, the character "/" in this document generally indicates that the associated objects before and after are in an "or" relationship.

In the description of the embodiments of the present disclosure, the term "a plurality of" refers to two or more (including two), similarly, "a plurality of groups" refers to two or more groups (including two groups), and "a plurality of pieces" refers to two or more pieces (including two pieces).

In the description of the embodiments of the present disclosure, the technical terms "center," "longitudinal," "transverse," "length," "width," "thickness," "upper," "lower," "front," "rear," "left," "right," "vertical," "horizontal," "top," "bottom," "inner," "outer," "clockwise," "counterclockwise," "axial," "radial," "circumferential," and the like indicate orientations or positional relationships based on the orientations or positional relationships shown in the drawings, and are only for the convenience of describing the embodiments of the present disclosure and simplifying the description, rather than indicating or implying that the referred device or element must have a specific orientation, be constructed and operated in a specific orientation, and therefore cannot be understood as a limitation to the embodiments of the present disclosure.

In the description of the embodiments of the present disclosure, unless otherwise expressly specified and limited, the technical terms "mount", "connect", "couple", "fix", etc. should be understood in a broad sense, for example, it may be a fixed connection, a detachable connection, or integrated; it may be a mechanical connection, an electrical connection; it may be a direct connection, an indirect connection through an intermediate medium, or an internal connection between two elements or an interaction relationship between two elements. For those of ordinary skill in the art, the specific meanings of the above terms in the embodiments of the present disclosure can be understood according to specific situations.

In the drawings corresponding to the embodiments of the present disclosure, for better understanding and description, the thicknesses and areas of layers are enlarged. When describing that a component (such as a layer, film, region, or substrate) is on or above the surface of another component, the component may be "directly" on the surface of the other component, or there may be a third component between the two components. On the contrary, when describing that a component is on the surface of another component or that another component is formed or disposed on the surface of a component, it means that there is no third component between the two components. In addition, when describing that a component is "substantially" formed on another component, it means that the component is not formed on the entire surface (or front surface) of the other component, nor is it formed on part of the edge of the entire surface.

In the description of the embodiments of the present disclosure, when a component is described as "comprising" or "including" another component, it does not exclude the presence of other components unless otherwise specified and defined, and other components may also be included. In addition, when a component such as a layer, film, region, or plate is described as being "on/located on" another component, it may be "directly on" the other component (i.e., on the surface of the other component without any other component between them), or there may be another component between them. Furthermore, when a component such as a layer, film, region, or plate is "directly located on" another component, or when a component such as a layer, film, region, or plate is located on the surface of another component, it means that no other component is located between them.

The terms used in the description of the various embodiments described herein are for the purpose of describing specific embodiments only and are not intended to be limiting. As used in the description of the various embodiments and the appended claims, "the part" is also intended to include the plural form, unless the context clearly indicates otherwise. Among them, components include layers, films, regions, plates, and other components.

The embodiments of the present disclosure will be described in detail below with reference to the drawings. However, those of ordinary skill in the art should understand that in the various embodiments of the present disclosure, many technical details are proposed to enable the reader to better understand the present disclosure. However, even without these technical details and various changes and modifications based on the following embodiments, the technical solution claimed in the present disclosure can be realized.

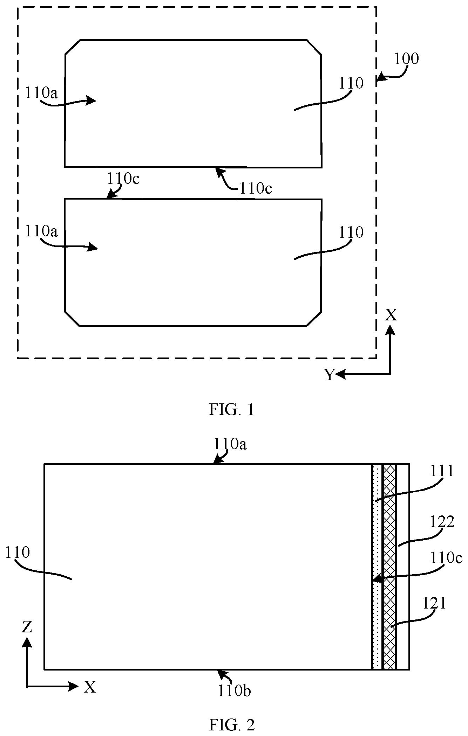

FIG. 1 is a first top view of a solar cell according to an embodiment of the present disclosure. FIG. 2 is a first cross-sectional view of a segmented cell in a solar cell according to an embodiment of the present disclosure.

According to some embodiments of the present disclosure, an aspect of the embodiments of the present disclosure provides a solar cell, which can improve the photoelectric conversion efficiency of segmented cells.

Referring to FIG. 1 and FIG. 2, the solar cell includes a segmented cell 110, where at least two segmented cells 110 are formed by performing a cutting process on the same whole solar cell 100 along a first direction. The segmented cell 110 includes a first surface 110a, a second surface 110b, and a third surface 110c connecting the first surface 110a and the second surface 110b. The first surface 110a is a part of the front surface of the whole solar cell 100, the second surface 110b is a part of the rear surface of the whole solar cell 100, and the third surface 110c is a section of the segmented cell 110 after the cutting process along the first direction. The solar cell further includes a crystalline silicon layer 111, where the crystalline silicon layer 111 is located on the third surface 110c. The solar cell further includes a silicon oxide layer 121, where the silicon oxide layer 121 is located on a surface of the crystalline silicon layer 111. The solar cell further includes a metal oxide layer 122, where the metal oxide layer 122 is located on the silicon oxide layer 121.

The segmented cell is formed by cutting a whole solar cell. The segmented cell may also be referred to as a solar cell. The segmented cell includes the first surface 110a, the second surface 110b, and the third surface 110c connecting the first surface 110a and the second surface 110b. This can be regarded as the solar cell including the first surface 110a, the second surface 110b, and the third surface 110c connecting the first surface 110a and the second surface 110b.

The crystalline silicon layer may also be referred to as a passivation region. The solar cell including the crystalline silicon layer means that the solar cell includes the passivation region, the passivation region is located on the third surface, and the silicon oxide layer is located on a surface of the passivation region.

The solar cell provided by the embodiments of the present disclosure, by disposing the crystalline silicon layer 111 on the third surface 110c of the segmented cell 110, passivates dangling bonds through the crystalline silicon layer 111, thereby reducing the number of dangling bonds on the section of the segmented cell 110, and thus avoiding the decrease in photoelectric conversion efficiency caused by the capture and recombination of minority carriers generated by light excitation when these minority carriers reach the surface by the dangling bonds. This can effectively hydrogenate the dangling bonds and reduce surface defects, significantly improve the minority carrier lifetime, increase the open-circuit voltage, and ultimately improve the photoelectric conversion efficiency. Moreover, by disposing the silicon oxide layer 121 and the metal oxide layer 122 on the crystalline silicon layer 111, the silicon oxide layer 121 can provide chemical passivation, and the metal oxide layer 122 can provide field passivation and chemical passivation, thereby reducing the recombination rate at the section and improving the photoelectric conversion efficiency of the segmented cell 110.

In addition, the crystals in the crystalline silicon layer 111 have a disordered structure or most of the crystals have a disordered structure, and The electron and hole mobility is low, so that the lateral conductivity is poor. In this way, short circuits and leakage currents caused by the connection between the first surface 110a and the second surface 110b of the segmented cell 110 through the crystalline silicon layer 111 can be effectively avoided, thereby improving the photoelectric conversion efficiency of the solar cell.

In some embodiments, the whole solar cell 100 may be any one of an IBC cell, a TOPCON cell, a PERC cell, and a heterojunction cell. Correspondingly, the segmented cell 110 may be any one of an IBC cell, a TOPCON cell, a PERC cell, and a heterojunction cell.

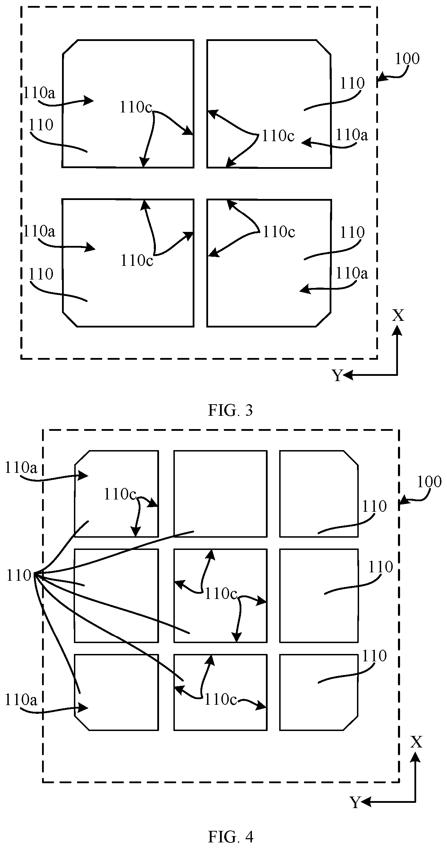

FIG. 3 is a second top view of a solar cell according to an embodiment of the present disclosure. FIG. 4 is a third top view of a solar cell according to an embodiment of the present disclosure.

The segmented cell 110 refers to a cell piece formed by cutting a whole cell piece into two or more cell pieces using a cutting technology. The current of each segmented cell piece is 1/n of the original whole cell piece, where n is the number of segmented cells formed by cutting the whole cell piece. According to different n, the segmented cells may include half-cut cells, third-cut cells, quarter-cut cells, eighth-cut cells, and any other segmented cells. For example, FIG. 1 shows half-cut cells, FIG. 3 shows quarter-cut cells, and FIG. 4 shows nine-cut cells.

It should be noted that, depending on the cutting position, the number of sections or cutting surfaces included in the segmented cell 110 may also be different. For example, the segmented cell 110 shown in FIG. 1 includes one cutting surface, the segmented cell 110 shown in FIG. 3 includes two cutting surfaces, and the segmented cell 110 shown in FIG. 4 partially includes two cutting surfaces, partially includes three cutting surfaces, and partially includes four cutting surfaces. The third surface 110c in the embodiments of the present disclosure may be any one or more of the cutting surfaces shown in FIG. 1, FIG. 3, and FIG. 4.

The segmented cell 110 may be formed by performing a cutting process along the first direction, where the first direction may be the X direction or the Y direction. The embodiments of the present disclosure take the first direction as the X direction as an example.

In some embodiments, the front surface of the whole solar cell 100 refers to the light-receiving surface of the whole solar cell 100, and the rear surface refers to the backlight surface of the whole solar cell 100. The backlight surface can also receive incident light, but the efficiency of receiving incident light is weaker than that of the light-receiving surface.

In some embodiments, the angle between the first surface 110a and the third surface 110c may be any value, that is, the cutting surface and the thickness direction Z of the whole solar cell 100 may intersect or be parallel to each other at any value. It is only necessary to ensure the break between two adjacent segmented cells 110. For example, the cutting surface shown in FIG. 2 is parallel to the thickness direction Z of the whole solar cell.

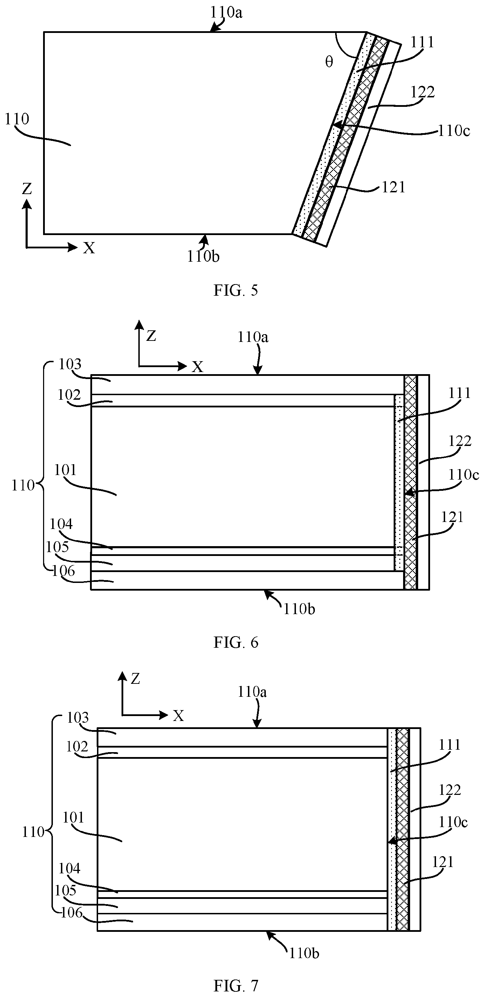

FIG. 5 is a second cross-sectional view of a segmented cell in a solar cell according to an embodiment of the present disclosure.

In some embodiments, referring to FIG. 5, the angle θ between the first surface 110a and the third surface 110c is an acute angle, that is, the cutting surface forms an acute angle with the thickness direction Z of the whole solar cell. In this way, the whole solar cell 100 is obliquely cut to form the segmented cell 110. For the first surface 110a and the second surface 110b of the segmented cell 110, the section of the segmented cell 110 can be regarded as an inclined surface. Based on this, compared to segmenting the entire solar cell along the thickness direction Z to form the cross-section of a segmented cell 110, the inclined section designed on the segmented cell 110 in this embodiment of the present disclosure has a smaller atomic arrangement density and a smaller covalent bond surface density, so that the connection between adjacent atoms on the section is not firm, which is more conducive to promoting the bonding between the crystalline silicon layer 111, the silicon oxide layer 121, and the metal oxide layer 122 located on the section and the dangling bonds on the section. That is, the crystalline silicon layer 111, the silicon oxide layer 121, and the metal oxide layer 122 may more easily saturate the dangling bonds on the section. Moreover, the crystalline silicon layer 111, the silicon oxide layer 121, and the metal oxide layer 122 can also passivate other surface defects on the section, which is conducive to further improving the ability of the crystalline silicon layer 111, the silicon oxide layer 121, and the metal oxide layer 122 to reduce the defect state density of the section, so as to reduce the recombination center of carriers and reduce the carrier recombination probability. In other words, designing the section of the segmented cell 110 to be inclined relative to the first surface 110a rather than vertical and cooperating with the passivation function of the crystalline silicon layer 111, the silicon oxide layer 121, and the metal oxide layer 122 is conducive to further improving the passivation effect of the crystalline silicon layer 111, the silicon oxide layer 121, and the metal oxide layer 122 on the section, so as to further reduce the probability of carrier recombination on the section, improve the carrier lifetime, and thereby further improve the photoelectric conversion efficiency of the segmented cell 110.

The substrate of the whole solar cell is crystalline silicon, and the crystal structure of crystalline silicon is a face-centered cubic unit cell structure. Due to the microscopic anisotropy of the crystalline silicon crystal, the distribution of atoms on different crystal planes in the crystalline silicon crystal is different. Among them, the (111) crystal plane of single crystal silicon has the smallest silicon atom density; the (110) crystal plane has the largest atom density. In some embodiments of the present disclosure, the segmented cell 110 is formed by oblique cutting, that is, more (111) planes are formed on the designed inclined fracture surface of the segmented cell 110. As a result, the fracture surface exhibits fewer dangling bonds, thereby enabling better passivation of the fracture surface by the crystalline silicon layer 111, the silicon oxide layer 121, and the metal oxide layer 122.

Referring to FIG. 5, the angle θ between the first surface 110a and the third surface 110c is an acute angle, and the acute angle may be 45° to 80°. If the acute angle is less than 45°, the inclination of the third surface 110c relative to the first surface 110a is too large, and the part of the segmented cell 110 including the third surface 110c may be regarded as a tip protruding from the entire segmented cell 110. The smaller the acute angle, the more protruding the tip, and the more likely the tip breaks under pressure, which is not conducive to improving the structural stability of the segmented cell 110. If the acute angle is greater than 80°, the inclination of the third surface 110c relative to the first surface 110a is too small, which is not conducive to reducing the atomic arrangement density on the third surface 110c, and thus not conducive to improving the passivation effect of the crystalline silicon layer 111 and the silicon oxide layer 121 on the third surface 110c. Therefore, designing the acute angle to be 45° to 80° controls the inclination of the third surface 110c relative to the first surface 110a, which is conducive to improving the structural stability of the segmented cell 110, reducing the probability of damage to the segmented cell 110, and effectively reducing the atomic arrangement density on the third surface 110c to improve the passivation effect of the crystalline silicon layer 111 and the silicon oxide layer 121 on the third surface 110c.

In some embodiments, the acute angle formed between the plane where the third surface 110c is located and the plane where the first surface 110a is located may be 45° to 50°, for example, the acute angle may be 46°, 47°, 48°, or 49°, which is conducive to making the third surface 110c approach the fcc (111) crystal plane of the segmented cell 110. It is worth noting that compared with other crystal planes, the fcc (111) crystal plane has the smallest atomic arrangement density and the smallest covalent bond surface density, and the connection between adjacent atoms is not firm. Based on this, designing the acute angle between the plane where the third surface 110c is located and the plane where the first surface 110a is located to be 45° to 50° is conducive to minimizing the atomic arrangement density on the third surface 110c, maximizing the ability of the crystalline silicon layer 111, the silicon oxide layer 121, and the metal oxide layer 122 to saturate the dangling bonds on the third surface 110c, thereby further improving the passivation effect of the crystalline silicon layer 111, the silicon oxide layer 121, and the metal oxide layer 122 on the third surface 110c, so as to further reduce the probability of carrier recombination on the third surface 110c, improve the carrier lifetime, and thereby further improve the photoelectric conversion efficiency of the segmented cell 110.

In some examples, the acute angle between the plane where the third surface 110c is located and the plane where the first surface 110a is located may also be 55°, 60°, 65°, 70°, 75°, or 80°, etc.

Continuing to refer to FIG. 2, in some embodiments, the crystalline silicon layer 111 may include an amorphous silicon layer or a microcrystalline silicon layer. In this way, the low-temperature process based on the amorphous silicon layer and the microcrystalline silicon layer may not affect the electrodes and various film layers on the segmented cell 110, effectively avoiding problems such as warping and reduction of doping concentration in the doping layer caused by high temperature. The doping layer may be an emitter or a doped polysilicon layer. In addition, the amorphous silicon layer and the microcrystalline silicon layer contain hydrogen ions, which can saturate dangling bonds, thereby providing good field passivation for the section and improving the photoelectric conversion efficiency of the segmented cell 110.

In some embodiments, the crystalline silicon layer 111 has a thickness of 1 nm to 10 nm. If the thickness of the crystalline silicon layer 111 is set to be less than 1 nm, the thickness of the crystalline silicon layer 111 is insufficient to provide enough hydrogen ions to perform hydrogen passivation treatment on the section. If the thickness of the crystalline silicon layer 111 is set to be greater than 10 nm, the optical absorption caused by the crystalline silicon layer 111 itself is large, which affects the photoelectric conversion efficiency of the segmented cell 110. The thickness of the crystalline silicon layer 111 provided in this embodiment is set between 1 nm and 10 nm. The crystalline silicon layer 111 provides more hydrogen ions and saturates the dangling bonds on the third surface 110c, reducing the carrier recombination rate on the third surface 110c, and the crystalline silicon layer 111 has less optical absorption, thereby improving the photoelectric conversion efficiency.

The thickness of the crystalline silicon layer 111 may be 1 nm, 2 nm, 3 nm, 4 nm, 5 nm, 6 nm, 7 nm, 8 nm, 9 nm, or 10 nm.

In some embodiments, the crystalline silicon layer 111 may include an intrinsic crystalline silicon layer, that is, the crystalline silicon layer 111 contains no doping elements. In this way, the intrinsic crystalline silicon layer has weak conductivity and poor mobility for both electrons and holes, which can effectively avoid edge leakage current.

In some embodiments, the crystalline silicon layer 111 may include a doped crystalline silicon layer, and the type of doping element may be the same as that of the film layer of the segmented cell 110 in contact. The doping element in the doped crystalline silicon layer may be diffused from the film layer of the segmented cell 110, or may be retained from a partial width of the film layer of the segmented cell 110 after amorphization treatment. In this way, the content of the doping element in the doped crystalline silicon layer is small, which is not enough to form a diffusion channel and an electric field, and thus cannot form a large edge leakage current, or even no edge leakage current.

In some embodiments, the crystalline silicon layer 111 may include a doped crystalline silicon layer, and the thickness of the crystalline silicon layer 111 is 1 nm to 10 nm. In this way, the thickness of the crystalline silicon layer 111 itself is thin, and the content of the doping element in the doped crystalline silicon layer is small, so that it will not form a large edge leakage current, or even no edge leakage current.

The crystalline silicon layer 111 being located on the third surface 110c includes two situations, which will be specifically described below with reference to specific drawings.

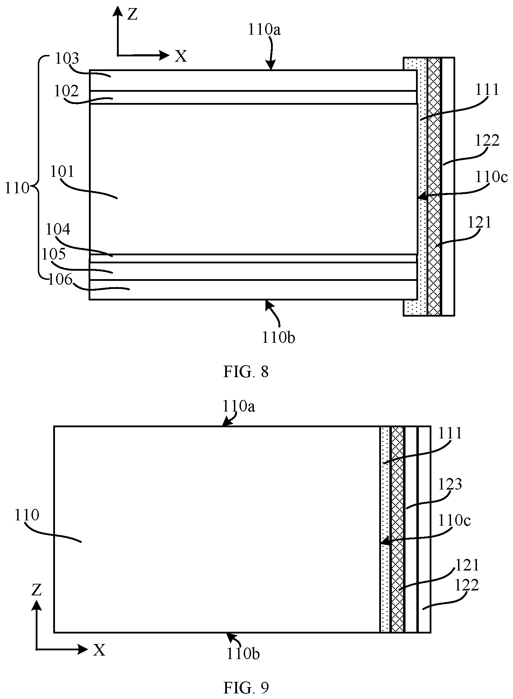

FIG. 6 is a third cross-sectional view of a segmented cell in a solar cell according to an embodiment of the present disclosure. FIG. 7 is a fourth cross-sectional view of a segmented cell in a solar cell according to an embodiment of the present disclosure. FIG. 8 is a fifth cross-sectional view of a segmented cell in a solar cell according to an embodiment of the present disclosure.

It should be noted that the solar cells shown in FIG. 6 to FIG. 8 are TOPCON cells. The embodiments of the present disclosure take the whole solar cell as a TOPCON cell as an example to illustrate the positional relationship between the crystalline silicon layer 111 and the film layers in the segmented cell 110. The whole solar cell at least includes a substrate 101 and a tunnel oxide layer 104 and a doped polysilicon layer 105 located on one side of the substrate 101.

Those skilled in the art can add functional film layers according to specific designs, for example, adding an emitter and a passivation layer on the other side of the substrate, for another example, adding a passivation layer on the surface of the doped polysilicon layer, and for yet another example, adding another tunnel oxide layer and another doped polysilicon layer on the other side of the substrate.

Referring to FIG. 6, the segmented cell 110 includes a substrate 101, and the substrate 101 has a first side and a second side opposite to each other. The segmented cell 110 includes an emitter 102, where the emitter 102 is located on the first side of the substrate 101. The segmented cell 110 includes a first passivation layer 103, where the first passivation layer 103 is located on a surface of the emitter 102. The segmented cell 110 includes a tunnel oxide layer 104 and a doped polysilicon layer 105, where the tunnel oxide layer 104 is located on the second side of the substrate 101, and the doped polysilicon layer 105 is located on a surface of the tunnel oxide layer 104. The segmented cell 110 includes a second passivation layer 106, where the second passivation layer 106 is located on a surface of the doped polysilicon layer 105.

It should be noted that the substrate, the emitter, the first passivation layer, the second passivation layer, the tunnel oxide layer, and the doped polysilicon layer are the substrate, emitter, first passivation layer, second passivation layer, tunnel oxide layer, and doped polysilicon layer known to those skilled in the art, and the embodiments of the present disclosure do not further describe them. The embodiments of the present disclosure take the substrate as an N-type single crystal silicon layer, the emitter as a P-type single crystal silicon layer, the first passivation layer as a silicon nitride layer, the second passivation layer as a silicon nitride layer, the tunnel oxide layer as a silicon dioxide layer, and the doped polysilicon layer as an N-type polysilicon layer as an example.

As for the first situation, referring to FIG. 6, the crystalline silicon layer 111 is located inside the segmented cell 110, that is, the crystalline silicon layer 111 is located on the inner side of the third surface 110c. The crystalline silicon layer 111 is formed by converting the film layer containing crystalline silicon crystals in the segmented cell 110 through amorphization treatment. In this way, the third surface 110c can be subjected to amorphization treatment, thereby reducing the number of dangling bonds on the third surface 110c and making it have a lower carrier recombination rate.

The film layer containing crystalline silicon crystals may be the substrate 101, the emitter 102, and the doped polysilicon layer 105.

It should be noted that in some examples, due to the thin thickness of the tunnel oxide layer 104, it may be amorphized into a part of the crystalline silicon layer 111. In some examples, the silicon element of the tunnel oxide layer 104 is still ordered silicon and has not been converted into disordered silicon (amorphous silicon or microcrystalline silicon), but due to the thin thickness, it cannot be reflected in the drawing and cannot be simply seen in practice.

As for the second situation, referring to FIG. 7, the crystalline silicon layer 111 is located outside the segmented cell 110, that is, the crystalline silicon layer 111 is located on the outer side of the third surface 110c. The crystalline silicon layer 111 is formed by a deposition process.

In some embodiments, referring to FIG. 6 or FIG. 7, the end surfaces of the crystalline silicon layer 111 are flush with the first surface 110a and the second surface 110b. In some embodiments, referring to FIG. 8, the crystalline silicon layer 111 extends to a part of the first surface 110a and the second surface 110b.

The silicon oxide layer 121 contains oxygen atoms, and the oxygen atoms form silicon-oxygen bonds with silicon dangling bonds. Moreover, the bond between O atoms and Si is more stable, accompanied by the transfer of electrons from Si to O, passivating the dangling bonds on the third surface 110c and the surface of the crystalline silicon layer 111, thereby passivating the third surface 110c and the crystalline silicon layer 111.

In some embodiments, referring to FIG. 2, the silicon oxide layer 121 includes an amorphous silicon oxide layer. The amorphous silicon oxide layer has less absorption of blue light, so that light of more wavelengths can be absorbed by the segmented cell 110, and thereby having low optical absorption, improving the photoelectric conversion efficiency of the segmented cell 110. Moreover, the amorphous silicon oxide layer has good passivation thermal stability, so that it can maintain a good passivation effect, effectively prolong the life of the silicon oxide layer 121 and the passivation life, and reduce the light-induced degradation efficiency of the segmented cell 110. The amorphous silicon oxide layer has a wide deposition process window, so it can be formed easily and stably, reducing the difficulty of the preparation process.

In some embodiments, the silicon oxide layer 121 includes a crystalline silicon oxide layer. The crystalline silicon oxide layer has good optical transparency and low optical loss, thereby reducing optical loss.

In some embodiments, the silicon oxide layer 121 has a thickness of 1 nm to 10 nm. In this way, the silicon oxide layer 121 provides more oxygen atoms and saturates the dangling bonds on the third surface 110c, reducing the carrier recombination rate on the third surface 110c, thereby improving the photoelectric conversion efficiency.

In some embodiments, the silicon oxide layer 121 has a thickness of 4 nm to 7 nm. The film formed by the silicon oxide layer 121 has high density, which can effectively prevent metal elements in the metal oxide layer from entering the crystalline silicon layer 111 and the segmented cell 110.

Moreover, the silicon oxide material also has a good anti-PID effect. Since the encapsulation material of the photovoltaic module formed based on the solar cell later is difficult to achieve 100% isolation from the outside world, water vapor may enter the inside of the solar cell through the encapsulation material or backsheet used for edge sealing in a humid environment. At this time, the glass in the encapsulation material may generate sodium ions, and the sodium ions may move to the surface of the solar cell under an external electric field, causing a PID phenomenon, which reduces the photoelectric conversion efficiency of the solar cell. The silicon oxide material has good density and insulation, so the silicon oxide material has a good effect on preventing water vapor from entering the third surface 110c and then entering the segmented cell 110, thereby having a good anti-PID effect. In this way, even if the encapsulation material of the photovoltaic module is difficult to achieve complete insulation, and water vapor enters the environment where the solar cell is located through the encapsulation material used for edge sealing, the film layer including the silicon oxide material can also prevent the sodium ions in the glass of the encapsulation material from moving to the third surface 110c, thereby preventing the PID phenomenon and keeping the photoelectric conversion rate of the solar cell high.

For example, the thickness of the silicon oxide layer 121 may be 1 nm, 2 nm, 3 nm, 4 nm, 5 nm, 6 nm, 7 nm, 8 nm, 9 nm, or 10 nm.

The metal oxide layer 122 may provide metal elements, and the metal elements make the metal oxide layer 122 itself have a high density of fixed charges. The high density of fixed charges can generate a large electric field, thereby providing good field effect passivation for the third surface 110c. For example, it may cause a large band bending between the metal oxide layer 122 and the third surface 110c, hindering the migration of minority carriers to the third surface 110c, reducing the concentration of minority carriers at the third surface 110c, and thus helping to reduce the recombination probability of majority carriers and minority carriers at the third surface 110c.

The formation energy of oxygen vacancies in the metal oxide layer 122 is less than the formation energy of oxygen vacancies in the silicon oxide layer 121, so that O atoms are easy to migrate from the metal oxide layer 122 to the substrate and the crystalline silicon layer 111, thereby further performing field passivation on the substrate and the crystalline silicon layer 111, and converting some silicon dangling bonds into silicon-oxygen bonds, thereby continuing to form the silicon oxide layer 121 and increasing the density of the silicon oxide layer 121. In substitution defects, the formation energy of silicon elements substituting metal elements in the metal oxide layer 122 is much greater than the formation energy of metal elements substituting silicon in the silicon oxide layer 121, so that metal elements are easily doped into the silicon oxide and release oxygen vacancies in the silicon oxide layer 121, further saturating dangling bonds.

In some embodiments, the metal elements in the metal oxide layer 122 include amorphous metal elements. In this way, a low-temperature process can be used to form the metal oxide layer 122, thereby avoiding thermal damage problems caused by high-temperature treatment processes.

In some embodiments, the metal elements in the metal oxide layer 122 may be any one or more of aluminum (Al), titanium (Ti), zinc(Zn), zirconium (Zr), hafnium (Hf), molybdenum (Mo), tungsten (W), or nickel (Ni).

In some embodiments, the metal oxide layer 122 may have a thickness of 20 nm to 100 nm. The thickness of the metal oxide layer 122 may be in a range of 20 nm to 40 nm, 40 nm to 60 nm, 60 nm to 80 nm, or 80 nm to 100 nm. For example, the thickness of the metal oxide layer 122 may be 23 nm, 38 nm, 45 nm, 56 nm, 69 nm, 83 nm, 91 nm, or 99 nm.

FIG. 9 is a sixth cross-sectional view of a segmented cell 110 in a solar cell according to an embodiment of the present disclosure.

In some embodiments, the solar cell further includes: an intermediate passivation region 123, where the intermediate passivation region 123 is located between the silicon oxide layer 121 and the metal oxide layer 122, and the intermediate passivation region 123 includes at least one of silicon element from the silicon oxide layer 121 or metal element from the metal oxide layer 122.

In some embodiments, the intermediate passivation region 123 may have a thickness of 4 nm to 15 nm. The thickness of the intermediate passivation region 123 may be 4 nm, 6 nm, 8 nm, 10 nm, 11 nm, 12 nm, 13 nm, or 14 nm.

In some embodiments, the intermediate passivation region 123 includes the metal element, and along a direction from the silicon oxide layer 121 toward the metal oxide layer 122, the content of the metal element increases.

The solar cell provided by the embodiments of the present disclosure, by disposing the crystalline silicon layer 111 on the third surface 110c of the segmented cell 110, passivates dangling bonds through the crystalline silicon layer 111, thereby reducing the number of dangling bonds on the section of the segmented cell 110, and thus avoiding the decrease in photoelectric conversion efficiency caused by the capture and recombination of minority carriers generated by light excitation when they reach the surface by the dangling bonds. This can effectively hydrogenate the dangling bonds and reduce surface defects, significantly improve the minority carrier lifetime, increase the open-circuit voltage, and ultimately improve the photoelectric conversion efficiency. Moreover, by disposing the silicon oxide layer 121 and the metal oxide layer 122 on the crystalline silicon layer 111, the silicon oxide layer 121 can provide chemical passivation, and the metal oxide layer 122 can provide field passivation and chemical passivation, thereby reducing the recombination rate at the section and improving the photoelectric conversion efficiency of the segmented cell 110.

In addition, the crystals in the crystalline silicon layer 111 have a disordered structure or most of them have a disordered structure, and the electron and hole mobilities are low, so that the lateral conductivity is poor. In this way, short circuits and leakage currents caused by the connection between the first surface 110a and the second surface 110b of the segmented cell 110 through the crystalline silicon layer 111 can be effectively avoided, thereby improving the photoelectric conversion efficiency of the solar cell.

Correspondingly, according to some embodiments of the present disclosure, another aspect of the embodiments of the present disclosure provides a method for fabricating a solar cell, which is used to fabricate the solar cell provided in the above embodiments. The same or corresponding technical features are not repeated here.

The fabrication method includes: referring to FIG. 1, providing a whole solar cell 100, where the whole solar cell 100 includes a front surface and a rear surface that are oppositely disposed.

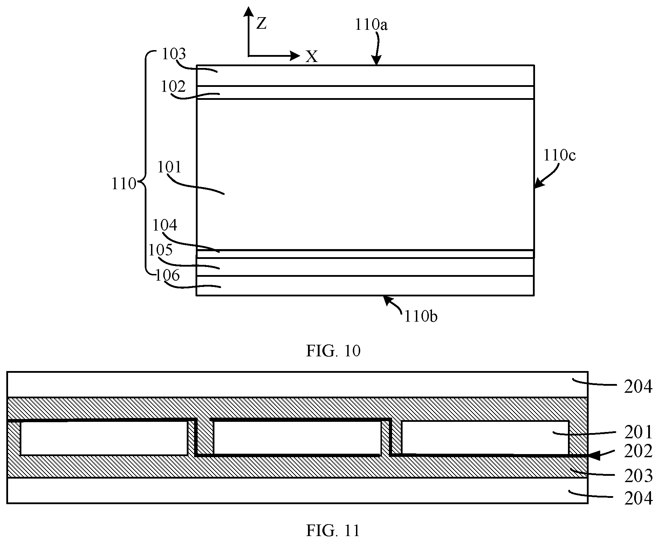

FIG. 10 is a cross-sectional view of a segmented cell during a method for fabricating a solar cell according to an embodiment of the present disclosure.

Referring to FIG. 10, the fabrication method includes: performing a cutting process on the whole solar cell along a first direction to form at least two segmented cells 110, where each segmented cell 110 includes a first surface 110a, a second surface 110b, and a third surface 110c connecting the first surface 110a and the second surface 110b, the first surface 110a is a part of the front surface of the whole solar cell, the second surface 110b is a part of the rear surface of the whole solar cell, and the third surface 110c is a section of the segmented cell 110 after the cutting process.

The fabrication method includes: referring to FIG. 2, forming a crystalline silicon layer 111, where the crystalline silicon layer 111 is located on the third surface 110c.

In some embodiments, the reaction temperature for forming the crystalline silicon layer 111 is less than or equal to 300°C.

In some embodiments, referring to FIG. 6, the whole solar cell 100 includes a substrate 101, and performing laser treatment on the substrate 101 to convert a part of the substrate 101 into the crystalline silicon layer 111.

In some embodiments, process parameters of the laser treatment include: a laser wavelength of 300 nm to 550 nm, a pulse width of 5 ps to 100 ns, a laser power of 1 W to 25 W, a pulse frequency of 50 kHz to 1250 kHz, a spot area of 5000 µm² to 50000 µm², and a scanning speed of 300 mm/s to 80000 mm/s.

In some embodiments, referring to FIG. 7, a deposition process is performed to form the crystalline silicon layer 111.

In some embodiments, referring to FIG. 8, the crystalline silicon layer 111 further extends to a part of the first surface 110a and the second surface 110b.

In some embodiments, using a plasma deposition process to form the crystalline silicon layer 111, so that the crystalline silicon layer 111 contains hydrogen ions. The hydrogen ions can perform hydrogen passivation on the third surface 110c, passivate the surface dangling bonds of the third surface 110c, and reduce the photoelectric conversion efficiency loss caused by recombination.

In some embodiments, after forming the crystalline silicon layer 111, performing hydrogen plasma treatment on the crystalline silicon layer 111 to increase the hydrogen ion content in the crystalline silicon layer 111. By performing hydrogen ion treatment on the crystalline silicon layer 111, the hydrogen ion content in the crystalline silicon layer 111 after the hydrogen ion treatment is higher, so that the hydrogen ions can combine with the dangling bonds on the third surface 110c to form non-recombination centers, thereby achieving a good passivation effect.

In some embodiments, the process of hydrogen plasma treatment includes: in the chamber where the crystalline silicon layer 111 is formed, after forming the crystalline silicon layer 111, continuing to introduce a hydrogen source gas, where the flow rate of the hydrogen source gas is 5000 sccm to 15000 sccm, and the radio frequency power is 10000 W to 15000 W.

The fabrication method includes forming a silicon oxide layer 121, where the silicon oxide layer 121 is located on the surface of the crystalline silicon layer 111.

In some embodiments, the reaction temperature for forming the silicon oxide layer 121 is less than or equal to 300°C.

The fabrication method includes: forming a metal oxide layer 122 on the silicon oxide layer 121.

In some embodiments, the reaction temperature for forming the metal oxide layer 122 is less than or equal to 300°C.

It should be noted that the above embodiments take the crystalline silicon layer 111 containing hydrogen ions as an example. During the process of forming the metal oxide layer 122 using a deposition process, hydrogen ions can also be formed through a nitrogen source or hydrogen source. The principle of the hydrogen atoms is the same as that of the hydrogen ions in the crystalline silicon layer 111, that is, the metal oxide layer 122 also contains a large amount of hydrogen, which can also form chemical passivation on the third surface 110c. Hydrogen plasma treatment can also be performed on the metal oxide layer 122 to increase the hydrogen ion content in the metal oxide layer 122.

Correspondingly, according to some embodiments of the present disclosure, yet another aspect of the embodiments of the present disclosure provides a photovoltaic module, which includes the solar cell provided in the above embodiments.

FIG. 11 is a cross-sectional view of a photovoltaic module according to an embodiment of the present disclosure.

Referring to FIG. 11, the photovoltaic module includes: a plurality of cell strings, each cell string is formed by connecting a plurality of solar cells 201 according to any one of the above embodiments or solar cells fabricated by the method according to any one of the above embodiments; at least one encapsulation film 203, configured to cover a surface of the plurality of cell strings; and at least one cover plate 204, configured to cover a surface of the at least one encapsulation film 203 away from the plurality of cell strings.

Specifically, in some embodiments, a plurality of cell pieces may be electrically connected through connecting members 202, and the connecting members 202 are welded to the busbars on the cell pieces. In some embodiments, the connecting members 202 are welded to the sub-grids on the cell pieces, and the sub-grids include a first electrode and a second electrode.

In some embodiments, there is no gap between the cell pieces, that is, the cell pieces overlap each other.

In some embodiments, the encapsulation film 203 includes a first encapsulation layer and a second encapsulation layer. The first encapsulation layer covers one of the front surface or the rear surface of the solar cell, and the second encapsulation layer covers the other of the front surface or the rear surface of the solar cell. Specifically, at least one of the first encapsulation layer or the second encapsulation layer may be an organic encapsulation film such as a polyvinyl butyral (PVB) film, an ethylene-vinyl acetate copolymer (EVA) film, a polyolefin elastomer (POE) film, or a polyethylene terephthalate (PET) film.

It is worth noting that the first encapsulation layer and the second encapsulation layer have a boundary before lamination treatment, but after lamination treatment to form the photovoltaic module, the concepts of the first encapsulation layer and the second encapsulation layer no longer exist, that is, the first encapsulation layer and the second encapsulation layer have formed an integral encapsulation film 203.

In some embodiments, the cover plate 204 may be a glass cover plate, a plastic cover plate, or other cover plates with light-transmitting function. Specifically, the surface of the cover plate 204 facing the encapsulation film 203 may be a concave-convex surface to increase the utilization rate of incident light. The cover plate 204 includes a first cover plate and a second cover plate. The first cover plate is opposite to the first encapsulation layer, and the second cover plate is opposite to the second encapsulation layer; or the first cover plate is opposite to one side of the solar cell, and the second cover plate is opposite to the other side of the solar cell.

Those of ordinary skill in the art should understand that the above various implementations are specific embodiments for implementing the present disclosure. In practical disclosures, various changes can be made in form and details without departing from the spirit and scope of the present disclosure. Any person skilled in the art can make various changes and modifications without departing from the spirit and scope of the present disclosure. Therefore, the protection scope of the present disclosure shall be defined by the claims.

## Claims

1. A solar cell, comprising:
a first surface, a second surface, and a third surface connecting the first surface and the second surface, wherein the first surface is a front surface of the solar cell, and the second surface is a rear surface of the solar cell;
a passivation region, located on the third surface;
a silicon oxide layer, located on a surface of the passivation region; and
a metal oxide layer, located on the silicon oxide layer.

2. The solar cell according to claim 1, wherein the passivation region includes an amorphous silicon layer or a microcrystalline silicon layer.

3. The solar cell according to claim 1 or 2, wherein the passivation region has a thickness of 1 nm to 10 nm.

4. The solar cell according to any one of claims 1 to 3, wherein the metal oxide layer is prepared by a low-temperature process.

5. The solar cell according to claim 1, wherein the silicon oxide layer has a thickness of 1 nm to 10 nm.

6. The solar cell according to claim 1, further comprising: an intermediate passivation region, wherein the intermediate passivation region is located between the silicon oxide layer and the metal oxide layer, and the intermediate passivation region includes at least one of silicon element from the silicon oxide layer or metal element from the metal oxide layer.

7. The solar cell according to claim 5, wherein the intermediate passivation region includes the metal element, and along a direction from the silicon oxide layer toward the metal oxide layer, the content of the metal element increases.

8. The solar cell according to claim 1, 5, 6, or 7, wherein the metal oxide layer has a thickness of 20 nm to 100 nm.

9. The solar cell according to claim 6 or 7, wherein the intermediate passivation region has a thickness of 4 nm to 15 nm.

10. The solar cell according to claim 1, wherein an angle between the first surface and the third surface is an acute angle.

11. A method for fabricating a solar cell, comprising:
providing a whole solar cell, wherein the whole solar cell includes a front surface and a rear surface opposite to each other;
performing a cutting process on the whole solar cell to form at least two solar cells, wherein a respective solar cell of the at least two solar cells includes a first surface, a second surface, and a third surface connecting the first surface and the second surface, the first surface is a part of the front surface of the whole solar cell, the second surface is a part of the rear surface of the whole solar cell, and the third surface is a section of the solar cell after the cutting process;
forming a passivation region on the third surface;
forming a silicon oxide layer on a surface of the passivation region; and
forming a metal oxide layer on the silicon oxide layer.

12. The method according to claim 11, wherein reaction temperatures for forming the passivation region, the silicon oxide layer, and the metal oxide layer are less than or equal to 300°C.

13. The method according to claim 11, wherein the solar cell includes a substrate, and forming the passivation region includes: performing laser treatment on the substrate to convert a portion of the substrate into the passivation region.

14. The method according to claim 13, wherein process parameters of the laser treatment include: a laser wavelength of 300 nm to 550 nm, a pulse width of 5 ps to 100 ns, a laser power of 1 W to 25 W, a pulse frequency of 50 kHz to 1250 kHz, a spot area of 5000 µm² to 50000 µm², and a scanning speed of 300 mm/s to 80000 mm/s.

15. A photovoltaic module, comprising:
a cell string, formed by connecting a plurality of solar cells according to any one of claims 1 to 10 or solar cells fabricated by the method according to any one of claims 11 to 14;
an encapsulation film, configured to cover a surface of the cell string; and
a cover plate, configured to cover a surface of the encapsulation film away from the cell string.
